# EUROPÄISCHE PATENTSCHRIFT

(11) **EP 4 144 894 B1**
(45) Veröffentlichungstag und Bekanntmachung des Hinweises auf die Patenterteilung: **18.06.2025**
(21) Anmeldenummer: 21195228.8
(22) Anmeldetag: 07.09.2021
(51) Int. Cl.: C30B 13/00, C30B 29/06, C30B 35/00

(54) **VERFAHREN ZUM HERSTELLEN EINES EINKRISTALLS AUS SILICIUM**
METHOD FOR PRODUCING A SINGLE CRYSTAL MADE OF SILICON
PROCÉDÉ DE PRODUCTION D'UN MONOCRISTAL À PARTIR DE SILICIUM

(43) Veröffentlichungstag der Anmeldung: 08.03.2023
(73) Patentinhaber: Siltronic AG, 81677 München (DE)
(72) Erfinder: Häckl, Walter, 84558 Kirchweidach (DE); Ratnieks, Gundars, 84489 Burghausen (DE); Sattler, Andreas, 83308 Trostberg (DE); Surovovs, Maksims, 1046 Riga (LV); Virbulis, Janis, 2107 Pinki, Babites pag. (LV)

(56) Entgegenhaltungen:
- JP-A- 2016 141 612
- US-A1- 2010 307 406
- US-A1- 2019 032 242
- DOLD P ET AL: "In situ observation of growth interfaces by ultrasound", JOURNAL OF CRYSTAL GROWTH, ELSEVIER, AMSTERDAM, NL, vol. 256, no. 3-4, 1 September 2003 (2003-09-01), pages 352 - 360, XP004440645, ISSN: 0022-0248, DOI: 10.1016/S0022-0248(03)01405-2

## Beschreibung

Gegenstand der Erfindung ist Verfahren zur Herstellung eines monokristallinen Stabes aus Silicium in einer Zonenziehanlage.

Das Zonenziehen von Einkristallen ist nach dem Stand der Technik bekannt (J. Bohm, u.a.:"Handbook of Crystal Growth", Ed.: D.T.J. Hurle, Vol. 2, Part A, 213-257, 1994) und wird im industriellen Maßstab zur Herstellung einkristalliner Materialien eingesetzt. Dabei wird mit einer Induktionsspule, in der ein Strom hoher Frequenz fließt, das Ausgangsmaterial in der Zone aufgeschmolzen, das dann beim Ziehen des Materials in vertikaler Richtung als Einkristall erstarrt, wobei der entstehende Einkristall meist gedreht wird. Je nach Ausführung des Verfahrens kann der Einkristall nach oben oder nach unten gezogen werden. Das elektromagnetische Feld der Induktionsspule erzeugt in der geschmolzenen Zone eine Strömung mit einer Doppelwirbelstruktur. Diese Strömung ist in der Mitte der Zone stets nach innen gerichtet, während in der Nähe der beiden Enden der Schmelzzone die Strömung stets radial nach Außen gerichtet ist. Die resultierende Strömung in der Schmelzzone wird neben den elektromagnetischen Kräften auch durch Auftriebs- und Marangoni-Kräfte sowie durch die Drehung von Stab oder Kristall erzeugt. Die Geometrie der erstarrenden Phasengrenze stellt sich entsprechend der im Stab herrschenden Temperaturverteilung ein, die wiederum durch die Strömungsverhältnisse beeinflusst wird.

Für die Strömungskontrolle beim Zonenziehen und die damit verbundenen Verbesserungen von Kristallqualität und Prozessstabilität sind Untersuchungen gemacht worden (A. Mühlbauer, u.a.: Journal of Crystal Growth, Vol. 151, 66-79, 1995; S. Otani, u.a.: Journal of Crystal Growth, Vol. 66, 419-425, 1984; S.Y. Zhang, u.a. Journal of Crystal Growth, Vol.243, 410-418, 2002), bei denen eine Optimierung der Prozessparameter Geometrie der Induktionsspule, Strom in der Induktionsspule, Rotation von Stab oder Kristall und Ziehgeschwindigkeit vorgeschlagen wird. So wurde versucht, die Homogenisierung der Dotierstoffverteilung durch Variation der Kristalldrehung, durch Verschiebung der Induktionsspule relativ zur Kristallachse oder durch eine optimierte Form der Induktionsspule zu erzielen.

In industriellem Maßstab wird das Zonenziehen insbesondere zur Herstellung von Einkristallen aus Silizium eingesetzt. Ein Einkristall wird dabei aus einem polykristallinen Vorratsstab ("feed rod") gewonnen, wobei wahlweise auch ein Vorratsstab aus monokristallinem Silizium verwendet werden kann.

Der Vorratsstab wird hierzu an einem Ende mit Hilfe einer Hochfrequenzspule ("inductor") angeschmolzen und ein einkristalliner Impfkristall an den entstandenen Schmelzentropfen angesetzt. Vom Vorratsstab nach und nach geschmolzenes Material dient als Nachschub für einen am Impfkristall in der Folge wachsenden Einkristall. Zunächst wird ein als Dünnhals ("neck") bezeichneter Längenabschnitt kristallisiert, um Versetzungen aus dem Kristallgitter zu lenken. Anschließend wird der Durchmesser des wachsenden Einkristalls in einem als Anfangskonus ("seed cone") bezeichneten Längenabschnitt auf einen Ziel-Durchmesser aufgeweitet. Danach erzeugt man einen Längenabschnitt, in dem der Einkristall den Ziel-Durchmesser aufweist. Zum Schluss des Verfahrens wird noch ein als Endkonus ("end cone") bezeichneter Längenabschnitt erzeugt. Wahlweise kann das Verfahren auch ohne Endkonus abgeschlossen werden, wobei dann aber ein Teil am Ende des Längenabschnitts mit dem Ziel-Durchmesser für die vorgesehene weitere Verarbeitung unbrauchbar ist, weil er Versetzungen aufweist.

Der Vorratsstab wird dabei mit einem Ende so an eine rotierbare Welle (Ziehwelle) montiert, dass er -auch wenn sich die Drehrichtung abrupt ändert- keinen Schlupf erfährt. Zudem ist die Anforderung, dass sich die Mitte des anderen Endes des Vorratsstabes während des Kristallziehens zu jedem Zeitpunkt auf der Rotationsachse der Ziehwelle befindet. Würde sich das Zentrum des anderen Endes von der Rotationsachse der Ziehwelle wegbewegen, würde das zu einer erheblichen Beeinflussung des Abschmelzens durch die Ziehspule führen, was wiederum das gesamte Ziehverfahren negativ beeinflussen kann.

Derzeit sind auf dem Markt lediglich monokristalline Stäbe aus Silizium mit einem Durchmesser von nominell bis zu 200 mm erhältlich, die mit dem Zonenziehverfahren hergestellt wurden.

Das Erreichen eines größeren Ziel-Durchmesser als 200 mm bei gleichzeitig maximierter Ziehgeschwindigkeit ist seit jeher ein bisher unerfüllter Wunsch der Industrie, da er größere Renditen (insbesondere auch bei der Herstellung von Bauelementen auf den daraus hergestellten Halbleiterscheiben) verspricht.

### Stand der Technik

Aus der Schrift DE 101 37 856 A1 ist ein Verfahren bekannt, durch tiegelloses Zonenziehen einen Einkristall aus Silicium herzustellen, der einen Durchmesser von mindestens 200 mm über eine Länge von mindestens 200 mm aufweist und im Bereich dieser Länge versetzungsfrei ist, wobei beim Zonenziehen ein Schmelzenhals zwischen einem Vorratsstab und dem Einkristall ausgebildet wird.

Es stellt sich jedoch heraus, dass die Ziehgeschwindigkeit zu klein ist, um wirtschaftlich sinnvoll Kristalle zu ziehen.

In der Patentschrift EP2142686 A1 wird ein Verfahren zur Herstellung eines Einkristalls offenbart, bei dem ein polykristalliner Stab durch einen Heizbereich geführt wird, um eine geschmolzene Zone zu erzeugen, ein Magnetfeld an die geschmolzene Zone angelegt wird und das Wachstum eines Einkristalls beim Erstarren des geschmolzenen Materials auf einem Einkristallkeim induziert wird. Der wachsende Einkristall wird in einem Muster abwechselnd im und gegen den Uhrzeigersinn in Rotation versetzt. Das Verfahren ist nützlich für die Herstellung von Silizium-Einkristallen mit gleichmäßigen elektrischen Charakteristika. Ebenfalls offenbart ist eine Vorrichtung zur Durchführung des Verfahrens. In den Ansprüchen wird zwar ein Kristall größer als 200 mm beansprucht, es wird jedoch kein Verfahren spezifisch für einen Durchmesser von 300 mm bereitgestellt.

Aus der Schrift US 2016 053 401 AA ist eine Zusatzheizvorrichtung für einen Zonenschmelzofen und ein Wärmeerhaltungsverfahren für einen Einkristallstab bekannt. Die Zusatzheizvorrichtung umfasst einen Zusatzheizer, der unterhalb einer Hochfrequenz-Heizspule im Inneren des Zonenschmelzofens angeordnet ist und durch Wickeln eines hohlen metallischen Rundrohrs gebildet wird. Das Wickelanfangsende des Zuheizers ist am oberen Teil positioniert, das Wickelanschlagende der Zuheizvorrichtung ist am unteren Teil positioniert, und ein oberes Endteil und ein unteres Endteil werden jeweils aus den beiden Enden herausgeführt; und eine hohlzylindrische Heizlast ist an der Innenseite des Zuheizers angeordnet, und ein Isolierteil ist zwischen der Heizlast und dem Zuheizer angeordnet. Die vorliegende Erfindung kann das Problem der Rissbildung an Einkristallstäben lösen, die durch eine unangemessene Verteilung des thermischen Feldes und übergroße thermische Spannungen im Wachstumsprozess von zonengeschmolzenen Silizium-Einkristallen über 6,5 Zoll verursacht wird.

Aus der Schrift DE 3 805 118 A1 sind Induktionsheizspulen bekannt, die geeignet sind für das tiegellose Ziehverfahren verwendet zu werden. Ebenfalls sind Methoden gezeigt, wie Spulen gegebenenfalls adaptiert werden können.

Die Schrift US 2010/307406 A1 beschreibt ein Verfahren zur Herstellung eines Kristalls zum Zonenziehen. Es wird dabei nicht auf die Art des Materials eingegangen, das verwendet werden soll. Der Kern dieses Dokuments behandelt die Art und Weise, wie das Halbleitermaterial beheizt werden soll. Auf die Verwendung einer Induktionsspule wird hier gänzlich verzichtet, da das Heizen des Halbleitermaterials durch die Verwendung von Infrarot-Lampen und entsprechend dimensionierte Spiegel bewerkstelligt wird.

Dold et al. ("In situ Observation of Growth Interfaces by Ultrasound", Journal of Crystal Growth, Elsevier, Amsterdam, NL, Bd. 256, Nr. 3-4, 1. September 2003 (2003-09-01), Seiten 352-360) beschreibt ein Verfahren wie Wachstumsstreifen mittels Ultraschall während des Kristallziehens gemessen werden können.

Die US 2019/032242 A1 beschreibt ein Verfahren mit dem ein Einkristall hergestellt wird, wobei ein sogenanntes "powder raw material" auf einen bereits hergestellten monokristallinen Stab aufgebracht wird und dort offenbar mittels Lampen geschmolzen wird.

Die Aufgabe der Erfindung ist es, ein Verfahren zur Verfügung zu stellen, das es ermöglicht, einen monokristallinen Stab mittels des FZ Ziehverfahrens herzustellen, wobei der Durchmesser größer ist als 200 mm, ohne dabei die Nachteile des Standes der Technik -wie zu geringe Ziehgeschwindigkeit- zu haben.

Die Aufgabe wird gelöst durch die in den Ansprüchen beschriebenen Verfahren.

### Kurzbeschreibung der Figuren

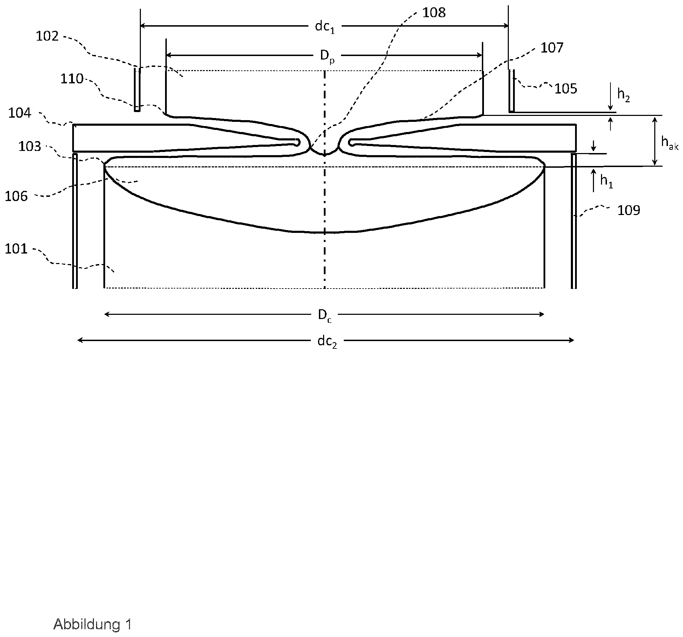

**Abbildung 1** zeigt einen axialen Schnitt einer Zonenziehanlage während des Kristallziehens wie es für das erfindungsgemäße Verfahren notwendig ist. Gezeigt ist ein Vorratsstab (102) mit einem Durchmesser **Dₚ**, ein erster Hohlzylinder (105) mit einem inneren Durchmesser **dc₁**, ein zweiter Hohlzylinder (109) mit einem inneren Durchmesser **dc₂**, ein monokristalliner Stab (101), eine Schmelze (106) und eine Spule (104).
   Die Größe **h₁** definiert dabei den vertikalen Abstand der Oberkante des zweiten Hohlzylinders (109) von der Kristallisationskante (103). Die Größe **h₂** definiert dabei den vertikalen Abstand der Unterkante des ersten Hohlzylinders (105) von der äußeren Abschmelzkante **(110)** des Vorratsstabes. Der vertikale Abstand zwischen der äußeren Abschmelzkante **(110)** und der Kristallisationskante **(103)** wird mit **hₐₖ** bezeichnet.
   Während des Kristallziehens wird der Vorratsstab **(102)** an der Abschmelzfront **(107)** geschmolzen. Der Punkt in der Abbildung, an dem der Vorratsstab, die Schmelze und der Gasraum zusammentreffen wird innen liegender Tripelpunkt **(108)** genannt.

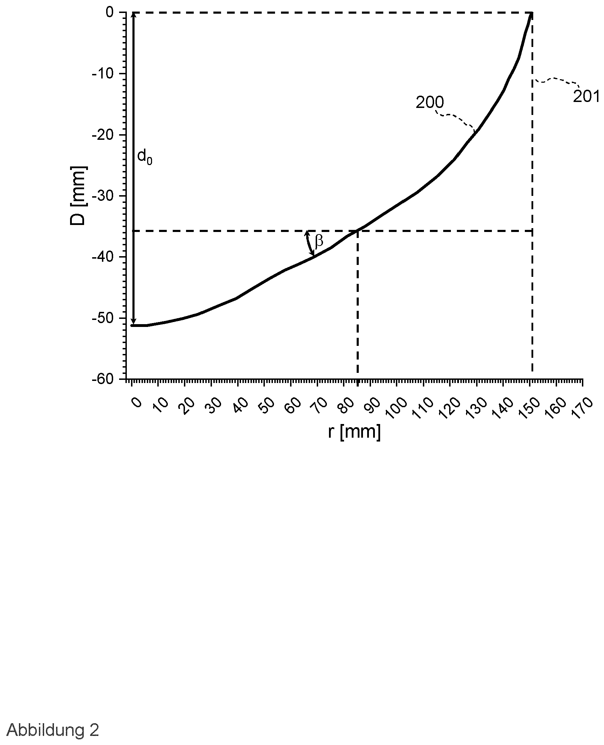

**Abbildung 2** zeigt die Kontur eines Wachstumsstreifens (200), die als Funktion des Radius des Kristalls und der Länge D des Kristalls in Wachstumsrichtung ermittelt wurde. Der Wert **d₀** bezeichnet dabei die maximale Durchbiegung des Wachstumsstreifens. Ein charakteristischer Parameter für das erfindungsgemäße Verfahren ist der Anstellwinkel **β,** der zwischen einer horizontalen Linie und einer an Wachstumsstreifen angelegten Tangente, die an der radialen Position 85 mm bestimmt wird.

### Abkürzungen

- **101**: monokristalliner Stab mit einem Durchmesser **D_{c}**
- **102**: Vorratsstab aus Silicium mit einem Durchmesser **Dₚ**
- **103**: Kristallisationskante des Einkristalls
- **104**: Spule
- **105**: erster Hohlzylinder mit einem inneren Durchmesser **dc₁**
- **106**: Schmelze
- **107**: Abschmelzfront des Vorratsstabes
- **108**: innen liegender Tripelpunkt
- **109**: zweiter Hohlzylinder mit einem inneren Durchmesser **dc₂**
- **110**: äußere Abschmelzkante des Vorratsstabes
- **h₂**: vertikaler Abstand der Unterkante des ersten Hohlzylinders von der äußeren Abschmelzkante
- **h₁**: vertikaler Abstand des zweiten Zylinders von der Kristallisationskante
- **hₐₖ**: vertikaler Abstand zwischen der Abschmelzkante und der Kristallisationskante
- **200**: Kontur eines Wachstumsstreifens, die als Funktion des Radius des Kristalls und der Länge D des Kristalls in Wachstumsrichtung ermittelt wurde.
- **201**: Mantelfläche des Kristalls
- β: Anstellwinkel zwischen einer horizontalen Linie und einer an Wachstumsstreifen angelegten Tangente, die an der radialen Position 85 mm bestimmt wird.
- **d₀**: maximale Durchbiegung der Wachstumsstreifen

### Detaillierte Beschreibung erfindungsgemäßer Ausführungsbeispiele

Gegenstand der vorliegenden Erfindung ist ein Verfahren zum Herstellen eines Einkristalls aus Silicium mittels des Zonenziehverfahrens.

Um die Aufgabe möglichst große Durchmesser und gleichzeitig hohe Wachstumsgeschwindigkeiten zu erreichen, haben die Erfinder erkannt, dass es notwendig ist, in die Ziehanlage einen Vorratsstab einzubauen, der einen Durchmesser von nicht weniger als 230 mm und nicht mehr als 270 mm aufweist.

Zudem ist es offenbar notwendig, dass beim Ziehen des Kristalls ein erster Hohlzylinders den Vorratsstab umgibt, der vorher eingebaut wurde. Der Innendurchmesser des Vorratsstabes darf dabei um nicht weniger als 30 mm und nicht mehr als 50 mm größer sein als der Durchmesser des Vorratsstabs. Im Wesentlichen soll dabei die Längsachse des ersten Hohlzylinder und die Längsachse des Vorratsstabes übereinanderliegen. Kleinere radiale Abweichungen von weniger als 3 mm sind manchmal unvermeidbar, jedoch ist es vorteilhaft, diese Abweichungen beim Einbau zu minimieren.

Es ist ferner notwendig, dass vor dem Krsitallziehen ein zweiter Hohlzylinders so eingebaut wird, dass er den später gezogenen einkristallinen Stab umgibt. Dabei darf sein Innendurchmesser um nicht weniger als 20 mm und nicht mehr als 60 mm größer sein als der Zieldurchmesser des einkristallinen Stabes. Soll also beispielsweise ein Kristall mit einem Zieldurchmesser von 300 mm gezogen werden, ist es bevorzugt, wenn der Innendurchmesser zwischen 320 mm und 360 mm beträgt.

Bevorzugt ist es, wenn der zylindrischen Teiles des Einkristalls einen Durchmesser von nicht weniger als 290 mm und nicht mehr als 310 mm aufweist und eine Länge hat, die 15 cm nicht unterschreitet. Die maximale Länge des zylindrischen Teils des Stabes hängt dabei im Wesentlichen von den Dimensionen der Kristallziehanlage ab.

Der Durchmesser eines Einkristalls ist prozessbedingt kleineren Schwankungen unterworfen, die zwar minimiert, aber nicht ganz eliminiert werden können. Es wird daher der Begriff des Zieldurchmessers als gemittelter Durchmesser des Einkristalls verstanden.

Wie in **Abbildung 1** gezeigt, bildet der Vorratsstab an der Abschmelzfront eine äußere Abschmelzkante und der monokristalline Stab an der Wachstumsseite eine Kristallisationskante.

Die Erfinder haben erkannt, dass beim Kristallziehen der vertikale Abstand der Unterkante des ersten Hohlzylinders von der äußeren Abschmelzkante des Vorratsstabes bevorzugt kleiner ist als 2 mm. Die Unterkante des ersten Hohlzylinders befindet sich dabei oberhalb der äußeren Abschmelzkante des Vorratsstabes. Der erste Hohlzylinder ist daher gegenüber der Abschmelzkante nach oben verschoben.

Besonders bevorzugt beträgt die Länge des ersten Hohlzylinders mindestens 10 cm und ist kleiner als 50 cm. Das Material aus dem der erste Hohlzylinder gefertigt ist, besteht bevorzugt aus Silber, wobei ganz bevorzugt für die innere Oberfläche des ersten Hohlzylinders eine Beschichtung ein Material ausgesucht wird, das eine hoher Emissivität aufweist.

Die Emissivität eines Körpers gibt an, wie viel Strahlung er im Vergleich zu einem idealen Wärmestrahler, einem schwarzen Körper, abgibt.

Gold, Silber, Silberlegierungen, Kohlenstoff oder Kupfer und dergleichen sind dabei gute Kandidaten, um eine Beschichtung durchzuführen, wobei die Verwendung von Gold, Silber oder Silberlegierungen vorzuziehen ist, da dabei die Gefahr einer Verunreinigung der Schmelze oder des Einkristalls nicht besteht.

Besonders bevorzugt kann der erste Hohlzylinder aus zwei Hohlzylindern zusammengesetzt sein, wobei ein unterer Hohlzylinder bevorzugt mit einer aktiven Heizung versehen sein kann. Die aktive Heizung könnte bevorzugt mittels eine ähnlichen Vorrichtung wie in US 2016 053 401 AA beschrieben ausgeführt sein.

Einen ganz besonderen Augenmerk legten die Erfinder darauf, dass die Oberkante des zweiten Zylinders über die Kristallisationskante hinausragt. Besonders bevorzugt ist dabei der vertikale Abstand zwischen Kristallisationskante und Oberkante des zweiten Hohlzylinders nicht weniger als 1 mm und nicht mehr als 10 mm.

Ebenso wie beim ersten Hohlzylinder ist das Material, aus dem der zweite Hohlzylinder gefertigt wird, so auszuwählen, dass die Emissivität auf der Innenseite Hohlzylinders möglichst hoch ist. Zusätzlich ist bevorzugt, dass der zweite Hohlzylinder aus zwei Hohlzylindern zusammengesetzt ist, die aus unterschiedlichen Materialien gefertigt wurden.

Bevorzugt wird der untere Teil des zweiten Hohlzylinders, also der Teil der eine größere Entfernung zur Spule aufweist, aus Silber gefertigt. Ganz besonders bevorzugt enthält er eine Oberflächenbehandlung, wie etwa eine Beschichtung mit Silber oder Gold oder Legierungen daraus auf der Innenseite, um die Emissivität zu maximieren.

Der obere Teil des zweiten Hohlzylinders, also der Hohlzylinder, der der Spule zugewandt ist, ist bevorzugt aus einem Material gefertigt, das zum einen eine hohe Emissivität auf der Innenseite aufweist und gleichzeitig robust ist gegenüber hohen Temperaturen (d.h. größer als 1000°C). Als Kandidaten hierfür empfehlen sich keramische Materialien oder auch Platin oder mit Platin beschichtete Keramiken.

Der zweite Hohlzylinder weist auch bevorzugt Durchbrüche und Löcher auf, die es ermöglichen, dass ein Bildverarbeitungssystem freie Sicht auf die Kristallisationskante des Einkristalls hat. Insbesondere ist darauf zu achten, dass diese Durchbrüche und Löcher so klein wie möglich und so groß wie nötig ausgeführt werden, da sie sich negativ auf den Ziehprozess auswirken können.

Die Ziehgeschwindigkeit beträgt bevorzugt nicht weniger als 1,3 mm/min und nicht mehr als 1,5 mm/min, bevorzugt nicht weniger als 1,35 mm/min und nicht mehr als 1,45 mm/min. Als Ziehgeschwindigkeit wird die Geschwindigkeit verstanden, mit der der einkristalline Stab in axialer Richtung wächst. Die Geschwindigkeit, mit der der Vorratsstab zugeführt werden muss, lässt sich bei gegebener Ziehgeschwindigkeit leicht über die entsprechende Massenbilanz ausrechnen.

Die Länge des zweiten Hohlzylinders beträgt bevorzugt mehr als 10 cm und nicht mehr als 40 cm.

Die Wandstärke der beiden Hohlzylinder beträgt bevorzugt nicht mehr als 10 mm und nicht weniger als 3 mm.

Wie im Stand der Technik für das Zonenziehverfahrens üblich, enthält der Gasraum Stickstoff, der sich in den gezogenen Kristall einbaut.

Kristalle, die nach dem eben beschriebenen Verfahren gezogen wurden, können wie herkömmliche Kristalle aus dem Ziehverfahren nach Czochralski weiterverarbeitet werden.

Bevorzugt umfasst die Weiterverarbeitung die Schritte das Rundschleifen des Einkristalls, das Ablängen des Stabes in Stabstücke, Sägen eines Stabstücke in Scheiben, das Schleifen und das Polieren der Scheiben des Einkristalls.

Halbleiterscheiben die aus Stäben gefertigt wurden, die nach dem eben beschriebenen Verfahren gefertigt wurden, sind hervorragend dafür geeignet, um mit ihnen Leistungsbauelemente zu fertigen, da sie sehr defektarm sind. Dafür verantwortlich ist, dass bei diesem Verfahren im Wesentlichen der interstitielle Sauerstoff fehlt, um Sauerstoffpräzipitate im Kristallgitter auszubilden. Ein Nenndurchmesser von 300 mm und eine hohe Ziehgeschwindigkeit macht diesen Prozess sehr wirtschaftlich und daher bisher unerreicht.

Nach Anwenden des erfindungsgemäßen Verfahrens erhält man einen monokristallinen Stab mit einem Nenndurchmesser von nicht weniger als 290 mm und nicht mehr als 330 mm. Dieser Stab wird bevorzugt in Stabstücke mit einer Länge von nicht weniger als 15 cm und nicht größer als 50 cm geschnitten.

Wird beispielsweise ein so erhaltenes Stabstück mit einem Durchmesser von 300 mm und einer Länge von 20 cm der Länge nach (also axial) aufgeschnitten, kann ein sogenanntes Brett mit einer Breite von 300 mm und einer Länge von 20 cm erhalten werden.

An einem Brett können Messungen durchgeführt werden, die sowohl den Kristall als auch das Ziehverfahren, mit dem der Kristall hergestellt wurde, charakterisieren.

Der Dotierstoff, der der Schmelze beim Zonenziehverfahrens meist gasförmig zugesetzt wird baut sich in den Kristall unregelmäßig ein. Bevorzugt enthält dabei der Dotierstoff Bor oder Phosphor. Dies führt zu einer lokal inhomogenen Widerstandsverteilung des Siliciums, die "Striations" genannt wird.

Obwohl es große Anstrengungen gibt, Striations zu vermeiden, um negative Auswirkungen beim Bauelementprozess nicht zu erleiden, sind dennoch Striations immer messbar, sobald der gezogene Stab im Zonenziehverfahrens dotiert wurde.

Da sich der Dotierstoff von der Schmelze in den Kristall entlang der Grenzfläche Schmelze/Kristall einbaut, lässt sich mittels der Analyse der gemessenen Widerstandsverteilung die ursprüngliche Form der Grenzfläche zwischen Kristall und Schmelze in Form von Wachstumsstreifen ermitteln. Beispielhaft seien zwei Literaturstellen genannt, die sich diesem Mess- und Auswerteverfahren widmen:
Investigation of defects and striations in as-grown Si crystals by SEM using Schottky diodes, Appl. Phys. Lett. 27, 313 (1975); https://doi.org/10.1063/1.88482, A. J. R. de Kock, S. D. Ferris, L. C. Kimerling, and H. J. Leamy
   und
Lüdge, A., Riemann, H.: Doping in homogeneities in silicon crystals detected by the lateral photovoltage scanning (LPS) Method. Inst. Phys. Conf. Ser. 160, 145-148 (1997).

Die letztgenannte Quelle (Lüdge et al.) beschreibt die Methode des "lateral photovoltage scanning" (LPS), die auch dann geeignet ist, die Grenzfläche zwischen Kristall und Schmelze, also die Wachstumstreifen, zu rekonstruieren, wenn der durch Dotierung eingestellte Widerstand hoch, also die Dotierstoffkonzentration gering ist.

Wird die Methode des "lateral photovoltage scanning" (LPS), auf das oben beschriebene Brett angewandt, können Konturen der Wachstumsstreifen ermittelt werden, die die Durchbiegung der Grenzfläche zwischen Schmelze und Kristall genau wiedergeben.

Eine Kontur eines Wachstumsstreifens eines Kristalls (200), der nach dem erfinderischen Verfahren gezogen wurde ist in **Abbildung 2** gezeigt.

Es können zwei charakteristische Größen abgeleitet werden, die die Eigenschaften des Kristallstückes beschreiben:
(1) die maximale Durchbiegung **d₀** der Wachstumsstreifen und
(2) der Anstellwinkel β zwischen einer horizontalen Linie und einer an Wachstumsstreifen angelegten Tangente, die an der radialen Position 85 mm bestimmt wird.

## Patentansprüche

1. Verfahren zum Herstellen eines Einkristalls aus Silicium, umfassend:
den Einbau eines Vorratsstabes aus Silicium in eine Vorrichtung zum Zonenziehen, wobei der Vorratsstab einen Durchmesser von nicht weniger als 230 mm und nicht mehr als 270 mm aufweist,
den Einbau eines ersten Hohlzylinders mit einer Unterkante und einem Innendurchmesser, der um nicht weniger als 30 mm und nicht mehr als 50 mm größer ist als der Durchmesser des Vorratsstabs, so dass beim Ziehen der Hohlzylinder den Vorratsstab umgibt und die Längsachse des ersten Hohlzylinders und die Längsachse des Vorratsstabes übereinanderliegen,
den Einbau eines zweiten Hohlzylinders mit einer Oberkante und einem Innendurchmesser, der um nicht weniger als 20 mm und nicht mehr als 60 mm größer und ist als der Zieldurchmesser des Einkristalls, so dass der zweite Hohlzylinder so eingebaut wird, dass er den zu ziehenden Einkristall umgibt,
Ziehen eines zylindrischen Teiles des Einkristalls, der einen Zieldurchmesser von nicht weniger als 290 mm und nicht mehr als 310 mm aufweist,
wobei der Vorratsstab an der Abschmelzfront eine äußere Abschmelzkante bildet und der monokristalline Stab an der Wachstumsseite eine Kristallisationskante bildet,
wobei die Ziehgeschwindigkeit nicht weniger als 1,3 mm/min und nicht mehr als 1,5 mm/min, bevorzugt nicht weniger als 1,35 mm/min und nicht mehr als 1,45 mm/min beträgt,
wobei der vertikale Abstand der Unterkante des ersten Hohlzylinders von der äußeren Abschmelzkante kleiner ist als 2 mm und
die Oberkante des zweiten Zylinders nicht weniger als 1 mm und nicht mehr als 10 mm über der Kristallisationskante hinausragt,
Ablängen des Einkristalls zu einem Stabstück mit einer Länge nicht weniger als 15 cm und nicht mehr als 50 cm.

2. Verfahren nach Anspruch 1, **dadurch gekennzeichnet, dass**
der vertikale Abstand zwischen der Abschmelzkante und der Kristallisationskante nicht kleiner ist als 35 mm und nicht größer ist als 40 mm.

3. Verfahren nach einem der vorigen Ansprüche, **dadurch gekennzeichnet, dass** der Vorratsstab mittels eines CZ Verfahrens hergestellt wurde.

4. Verfahren nach einem der vorigen Ansprüche, **dadurch gekennzeichnet, dass** das Verfahren ferner umfasst die Schritte
Rundschleifen des Einkristalls,
Sägen des Stabstückes in Scheiben,
das Schleifen und das Polieren der Scheiben.

## Claims

1. Process for producing a single crystal of silicon, comprising:
the installing of a feed rod of silicon in a float-zone apparatus, the feed rod having a diameter of not less than 230 mm and not more than 270 mm,
the installing of a first hollow cylinder having a bottom edge and an internal diameter which is larger by not less than 30 mm and not more than 50 mm than the diameter of the feed rod, so that during pulling, the hollow cylinder surrounds the feed rod and the longitudinal axis of the first hollow cylinder and the longitudinal axis of the feed rod lie one above the other,
the installing of a second hollow cylinder having a top edge and an internal diameter which is larger by not less than 20 mm and not more than 60 mm than the target diameter of the single crystal, so that the second hollow cylinder is installed in such a way that it surrounds the single crystal to be pulled;
pulling a cylindrical part of the single crystal which has a target diameter of not less than 290 mm and not more than 310 mm,
where the feed rod at the melting front forms an outer melting edge and the monocrystalline ingot on the growth side forms a crystallizing edge,
where the pulling speed is not less than 1.3 mm/min and not more than 1.5 mm/min, preferably not less than 1.35 mm/min and not more than 1.45 mm/min,
where the vertical distance of the bottom edge of the first hollow cylinder from the outer melting edge is smaller than 2 mm, and
the top edge of the second cylinder protrudes not less than 1 mm and not more than 10 mm over the crystallizing edge,
removing a length of the single crystal to form an ingot piece having a length of not less than 15 cm and not more than 50 cm.

2. Process according to Claim 1, **characterized in that** the vertical distance between the melting edge and the crystallizing edge is not smaller than 35 mm and not larger than 40 mm.

3. Process according to any of the preceding claims, **characterized in that**
the feed rod has been produced by means of a CZ process.

4. Process according to any of the preceding claims, **characterized in that**
the process further comprises the steps of circularly grinding the single crystal,
sawing the ingot piece into wafers,
the grinding and the polishing of the wafers.

## Revendications

1. Procédé de production d'un monocristal de silicium, comprenant :
le montage d'une tige de réserve en silicium dans un dispositif pour l'étirage par zones, la tige de réserve présentant un diamètre qui n'est pas inférieur à 230 mm et pas supérieur à 270 mm,
le montage d'un premier cylindre creux présentant un bord inférieur et un diamètre interne, qui n'est pas inférieur de 30 mm et pas supérieur de 50 mm au diamètre de la tige de réserve, de telle sorte que lors de l'étirage, le cylindre creux entoure la tige de réserve et l'axe longitudinal du premier cylindre creux et l'axe longitudinal de la tige de réserve sont superposés,
le montage d'un deuxième cylindre creux présentant un bord supérieur et un diamètre interne qui n'est pas inférieur de 20 mm et pas supérieur de 60 mm au diamètre cible du monocristal, de telle sorte que le deuxième cylindre creux est monté de manière à entourer le monocristal à étirer,
étirage d'une partie cylindrique d'un monocristal, qui présente un diamètre cible qui n'est pas inférieur à 290 mm et pas supérieur à 310 mm,
la tige de réserve formant, au niveau du front de fusion, un bord de fusion externe et la tige monocristalline formant, au niveau du côté croissance, un bord de cristallisation,
la vitesse d'étirage n'étant pas inférieure à 1,3 mm/min et pas supérieure à 1,5 mm/min, de préférence pas inférieure à 1,35 mm/min et pas supérieure à 1,45 mm/min, la distance verticale entre le bord inférieur du premier cylindre creux et le bord de fusion externe étant inférieure à 2 mm et
le bord supérieur du deuxième cylindre ne dépassant pas de moins de 1 mm et pas de plus de 10 mm au-dessus du bord de cristallisation,
coupe du monocristal à un morceau de tige d'une longueur qui n'est pas inférieure à 15 cm et pas supérieure à 50 cm.

2. Procédé selon la revendication 1, **caractérisé en ce que**
la distance verticale entre le bord de fusion et le bord de cristallisation n'est pas inférieure à 35 mm et pas supérieure à 40 mm.

3. Procédé selon l'une des revendications précédentes, **caractérisé en ce que**
la tige de réserve a été produite au moyen d'un procédé CZ.

4. Procédé selon l'une des revendications précédentes, **caractérisé en ce que**
le procédé comprend en outre les étapes de :
rectification cylindrique du monocristal,
sciage du morceau de tige en disques,
ponçage et polissage des disques.
